(19) Europäisches Patentamt
European Patent Office
Office européen des brevets

(11) **EP 3 848 484 A2**

(12) **EUROPEAN PATENT APPLICATION**

(43) Date of publication:
**14.07.2021 Bulletin 2021/28**

(21) Application number: **20020015.2**

(22) Date of filing: **10.01.2020**

(51) Int Cl.:
*C23C 28/04* (2006.01)    *C23C 16/02* (2006.01)
*C23C 16/12* (2006.01)    *C23C 16/14* (2006.01)
*C23C 16/40* (2006.01)    *C23C 16/56* (2006.01)
*C23C 30/00* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **Ruppi, Sakari**
**8600-780 Lagos (PT)**

(72) Inventor: **Ruppi, Sakari**
**8600-780 Lagos (PT)**

(54) **IMPROVED ALUMINA LAYER DEPOSITED AT LOW TEMPERATURE**

(57)    The present invention relates to a coated cutting tool consisting of a substrate of cemented carbide, cermet, ceramics, steel or a superhard material such as cubic boron nitride (CBN) at least partially coated with a coating consisting of at least one outer layer of 2 to 10 $\mu$m, preferably 3 to 6 $\mu$m, thick $\alpha$-Al$_2$O$_3$ layer deposited by chemical vapour deposition (CVD) on an inner layer of 0.5-20 $\mu$m thick, preferably 4 to 8.5 $\mu$m thick Ti$_{1-x}$Al$_x$N, Ti$_{1-x}$Al$_x$CN or TaC$_{1-x}$N$_x$ or combinations thereof wherein the said $\alpha$-Al$_2$O$_3$ exhibits an X-ray diffraction pattern, as measured using CuK$_\alpha$ radiation and theta-2theta scan, and texture coefficients TC(hkl) being determined according to Harris formula with one dominant texture coefficient 4<TC(hkl)<7, selected from the reflections (110), (300), (102), (104) and (00 12). The dominating TC(hkl) being determined by H$_2$S/CO$_2$ ratio. The $\alpha$-Al$_2$O$_3$ layer is deposited in a temperature range of 600-800 °C being particularly useful in facilitating deposition of $\alpha$-Al$_2$O$_3$ layers on metastable materials like cubic Ti$_{1-x}$Al$_x$N. The deposition process is characterized by improved texture-control and by relatively very high growth rates.

EP 3 848 484 A2

Printed by Jouve, 75001 PARIS (FR)

**Description**

FIELD OF THE INVENTION

The present invention relates to a cutting tool insert and the method of manufacturing the same, the cutting tool insert consisting of a substrate of cemented carbide, cermet, ceramics, steel or a superhard material such as cubic boron nitride (CBN) and being at least partly coated with a coating of a total thickness of maximum of 35 $\mu$m consisting one or more refractory layers of which at least one is (110), (100), (104), (012) or (001) textured $\alpha$-$Al_2O_3$. The coated cutting tool in accordance with the present invention is particularly useful in applications with high demands of abrasive wear resistance and toughness. The present invention further relates to a process to produce the $\alpha$-$Al_2O_3$ layers with controlled textures in a temperature range of 600-800 °C being particularly useful in facilitating deposition of $\alpha$-$Al_2O_3$ layers on metastable materials like cubic $Ti_{1-x}Al_xN$.

BACKGROUND OF THE INVENTION AND PRIOR ART

Today, both alpha $\alpha$-$Al_2O_3$ and $\alpha$-$Al_2O_3$ polymorphs are used as hard coatings, and they can be deposited in a controlled way by modern CVD technology shown, for example in U.S. Patents 5,137,774 and 5,700,569

The control of the $\alpha$-$Al_2O_3$ polymorph in industrial scale was achieved in the beginning of the 1990's with commercial products based on US patent 5,137,774. Later modifications of this patent have been used to deposit $\alpha$-$Al_2O_3$ with preferred textures. In US 5,654,035 an alumina layer with the (012) texture and in US 5,980,988 an alumina layer with the (110) texture are disclosed. In US 5,863,640 the (012), (104) and (110) textures are disclosed. US 6,333,103 describes a modified method to control the nucleation and growth of $\alpha$-$Al_2O_3$ on the (10(10)) plane. US 6,869,668 describes a method to obtain a strong (100) texture in $\alpha$-$Al_2O_3$ using a texture modifying agent ($ZrCl_4$).

US 7,094,447 describes a technique to achieve a pronounced (012) texture. Enhanced deposition techniques to produce pronounced (104) and (116) textures are disclosed in US2006/0199026 and US 2006/0141271, respectively. The prior-art processes discussed above use all deposition temperatures of about 1000 °C.

US 7993742B2 and EP1953258B1/US2008187774B2 disclose (001) textured alumina layers. The (012), (104) and (001) textured alumina layers are compared and the (001) texture is found superior to the other textures. In the above-mentioned disclosures the textures of the alumina layers were determined by using XRD and quantified by texture coefficients (TC). In US 7763346B2 and EP01479B1 (US7201956) EBSD has been used to claim the (001) texture and quantified by inclination of the basal (001) plane. Despite the techniques used the (001) textured alumina coatings are claimed to be superior to other textured coatings.

However, in prior art the texture control of $\alpha$-$Al_2O_3$ has been performed by trial and error. The prior-art reveals that the important aspects of the texture control have clearly not been realized this being especially important to understand when depositing (001) textured $\alpha$-$Al_2O_3$ layers.

In a recent US patent application 2018/0274091 A1 effects of $H_2S$ on the growth and texture of $\alpha$-$Al_2O_3$ has been studied. The inventors claim that nucleation surface (oxidation treatment) is important to pre-determine the texture, however, they simultaneously emphasize that $\alpha$-$Al_2O_3$ starts to grow having (110) texture during uncatalyzed ($H_2S$ =0) growth of $\alpha$-$Al_2O_3$ independent on the nucleation surface. This is contractionary. Further, according to this application (US 2018/0274091 A1) the growth rate of $\alpha$-$Al_2O_3$ increases with increasing $H_2S$ level and reaches a plateau at 0.048 vol% of $H_2S$. This result is obtained using $CO_2$ concentration of 2.49 vol %. The $CO_2$ levels used in this application were very limed being from 2.01 to 4.87 vol %. In addition, the maximum level of $H_2S$ in this this application was only about 0.25 vol %. It is emphasized that the standard procedures used to deposit $\alpha$-$Al_2O_3$ for decades have started uncatalyzed ($H_2S$ = 0) for about 15-60 minutes, usually 30 min. As will be discussed later, this results in the formation of (110) texture, which can thus be found in all prior-art $\alpha$-$Al_2O_3$ layers next to the nucleation surface. Further, it should be noted that the process data disclosed in US 2018/0274091 A1, for example, for (001) $\alpha$-$Al_2O_3$ does not results in this texture according to the present invention, and as clear from the Examples given below.

US8389134 discloses a CVD coated cutting tool comprising an outer alumina layer and an inner cubic $Ti_{1-x}Al_xN$ layer containing not more than 25% of hexagonal AIN phase. Low temperature processes to deposit $\gamma$-$Al_2O_3$ alumina and $\alpha$-$Al_2O_3$ has been disclosed in US6572991 (B1) and WO2018/138255 (A1), respectively. WO2018/138255 (A1) discloses a deposition process for $\alpha$-$Al_2O_3$ without any profound texture carried out at 850 °C on a $Ti_{1-x}Al_xN$ layer. The deposition is carried out at too high a temperature and the growth rate is relatively low (4.5 hours at 850 °C to obtain about 3 $\mu$m $\alpha$-$Al_2O_3$) resulting in excessive heat treatment of the $Ti_{1-x}Al_xN$ layer. The result will be at least partial transformation of the cubic $Ti_{1-x}Al_xN$ phase.

It is important to realize that the prior-art low temperature processes for the $\alpha$-$Al_2O_3$ layers are generally deposited using process data giving an average growth rate for alumina coating of about 0.2 to 0.7 $\mu$m/h, usually less than about 0.5 $\mu$m/h. There is consequently a need to enhance the deposition rate in the CVD reactor with simultaneous improvements in texture control.

OBJECT OF THE INVENTION

It is an object of this invention is to avoid and alleviate the problems of the prior art and provide an $\alpha$-$Al_2O_3$ layer deposited in a temperature range of 600-800 °C, preferably 700-800 °C and most preferably 775-800 °C, with well-defined growth textures of (110), (100), (104), (012), and (001), on cubic $Ti_{1-x}Al_xN$, $Ti_{1-x}Al_xCN$, Ti(C,N) or $TaC_{1-x}N_x$ layers providing improved physical properties to a such cutting tool insert i.e. improved wear resistence and improved comb crack resistance. The improved properties are important in both turning and milling.

DESCRIPTION OF THE INVENTION

This invention provides a method to control deposition of $\alpha$-$Al_2O_3$ so that the growth textures (110), (100), (104), (012), and (001) can be achieved by controlling the ratio of only two important process variables, namely the $H_2S$ and $CO_2$. This surprising observation holds in a wide temperature range from about 600 to about 1050°C and surprisingly also in the temperature range of 600-800 C°. The invention allows deposition of all above mentioned textures using a wider process window as far as the $H_2S/CO_2$ ratio is kept in the limits disclosed in this application. This, in turn allows higher growth rates, well-controlled smaller grain sizes and thus improved cutting properties and improved crater wear and chipping resistance over the prior-art.

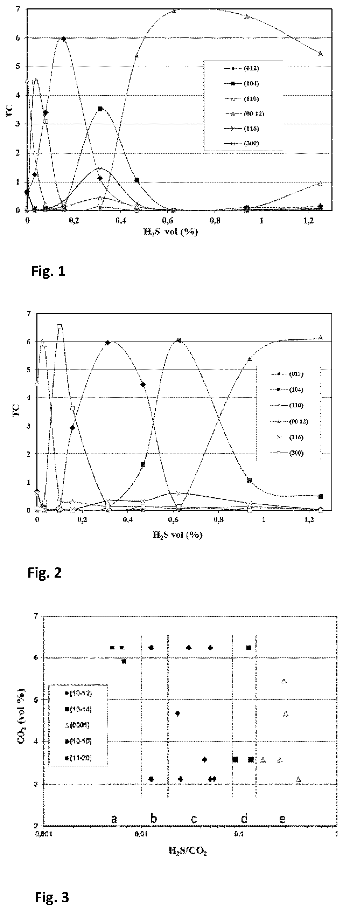

The present inventor has studied the texture development in CVD $\alpha$-$Al_2O_3$, and the observations are described in Figs. 1-4 and below:

The texture development was studied using $H_2S$ concentrations of 0.004-2.2 vol% and $CO_2$ concentrations from about 3.25 to 12 vol% in the temperature range of 600-1050 °C. The $\alpha$-$Al_2O_3$ layers were deposited onto layers comprising $Ti_{1-x}Al_xN$, $Th_{1-x}Al_xCN$, MT-CVD Ti(C,N) and $TaC_{1-x}N_x$ with a thickness of about 5-10 $\mu$m using the bonding and nucleation procedures disclosed in this application. The correct nucleation and bonding procedures are of crucial importance.

Fig. 1 demonstrates the development of texture coefficients (TC) for (110), (300), (012), (104) and (00 12) determined by XRD and using the Harris formula (presented and explained later in the text) as a function of $H_2S$ concentrations of 0-1.5 at $CO_2$ = 3,25 vol %:

The maximum values for TC(300), TC(012) and TC(104) appeared at about 0.08, 0.16 and 0.32 vol % of $H_2S$, respectively. At $H_2S$ levels exceeding ~ 0.6 vol % a high TC(00 12) started to develop reaching TC(00 12) > 6 at $H_2S$ levels from ~ 0.6 to -1.1 vol%. The total absence of the (00 12) reflection at $H_2S$ < 0.3 vol % should be noted. Further, it should be noted that relatively very low TCs for (110) were detected in all experiments at $CO_2$ = 3.35 vol%. The results also suggest that at the $H_2S$ concentrations exceeding ~ 0.9 vol%, the intensity of (00 12) reflection started to decline with the re-appearance of TC(110). The surprising observation was that the texture of $\alpha$-$Al_2O_3$ is determined by the $H_2S/CO_2$ ratio of the reactive gases in the CVD reactor during deposition of $\alpha$-$Al_2O_3$.

Fig. 2 demonstrates the development of texture coefficients (TC) for (110), (300), (012), (104) and (00 12) determined by XRD and using the Harris formula (presented and explained later in the text) as a function of $H_2S$ concentrations of 0-1.5 at $CO_2$ = 6,25 vol %:

A relatively very high TC(110), was detected at very low concentrations of $H_2S$ ($H_2S$ ~ 0.03 vol %). Further, relatively very high texture coefficients (>5.5) for (300), (110) and (104) reflections at $H_2S$ levels of about 0.08, 0.32 and 0.7 vol %, respectively, could be distinguished. At $H_2S$ concentrations exceeding ~ 1 vol % the TC(00 12) started to dominate. The highest TC (00 12) = 6.3 was obtained at $H_2S$ = 1.2 vol%. It was also noticed that when $H_2S/CO_2$ ratio exceeded 0.4 the TC(00 12) started to decline. A surprising observation was that the texture-regimes of $\alpha$-$Al_2O_3$ are now (at higher $CO_2$ concentration) very clearly separated. It is very clear that this has not been realized in the prior art. It appears that $CO_2$ concentrations exceeding 5-6 vol% should be used for easier control the textures.

It is noted that TC(006) and TC(00 12) behave in similar way and consequently both can be used to evaluate the existence of the (001) texture. Consequently, either TC(006) or TC(00 12) can be used. The use of (006) reflection instead of (00 12) will give identical results.

In an additional experiment the $\alpha$-$Al_2O_3$ layer was deposited without $H_2S$ using a very long deposition time of about 20 hours (due to the low growth rate without $H_2S$). This layer exhibited a (110)-texture being of the order 4.4 as confirmed by XRD using Harris formula as explained later in the text. This observation supports the results presented earlier that TC(110) is combined with low or zero $H_2S$.

Consequently, as shown in Fig. 3 it is possible to define regimes of the $H_2S/CO_2$ volume ratio (deposition windows) to produce one dominating texture being either (110), (100), (012), (104) or (001). The (100) texture is quantified and confirmed by the TC(300) and the (001) texture is quantified and confirmed by either TC(006) or TC(00 12). It is noted that Fig. 3 uses Miller-Bravais indexing i.e. (hkil), where i = -(h+k), as will be explained later in the text. Some results of the experiments with identified and verified textures (based on 2 repetitions) are depicted on Fig. 3 as a function of $H_2S/CO_2$ (0.004 < $H_2S/CO_2$ < 0.4). $CO_2$ concentrations used in this experiment were from about 3.25 vol % to about 6.50 vol %. As indicated on Fig. 3, (110) texture could only be obtained when $H_2S/CO_2$ $\leq$ 0.01 (field a in Fig. 3) and (100) texture existed when 0.01 < $H_2S/CO_2$ < 0.02 (field b in Fig. 3). Thus, to facilitate deposition of (110) and (100)

textures very low $H_2S/CO_2$ ratios must be applied. The (110) and (300) reflections were absent at higher $H_2S/CO_2$ values and, instead, TC(012) was found in the experiments when $0.02 \leq H_2S/CO_2 < 0.1$ (field c, Fig. 3). When $H_2S/CO_2$ exceeded 0.16 - 0.18 the (001) texture [either high TC(006) or TC(00 12)] dominated (field e, Fig. 3). In between the (012) and (001) windows the results suggest the presence of (104) texture (field d, Fig. 3). The process windows for (110), (100) and (104) textures appeared to be narrow as compared with the process windows for (012) and (001) textures. It is emphasized that there are naturally no abrupt boarders separating these process windows (fields a, b, c, d and e) indicated in Fig. 3. As clear from Fig. 3, the $H_2S/CO_2$ ratio is an important parameter, which can be used to control the texture of $\alpha$-$Al_2O_3$. Even though in this connection the effect of $H_2S$ concentration was evaluated at constant $CO_2$ levels it should be noted that based on the present results is straightforward to conclude that the $H_2S/CO_2$ ratio can also be changed by varying the $CO_2$ concentration at a constant $H_2S$ level. In the preferred embodiments more precise limits for the $H_2S/CO_2$ ratios will be given.

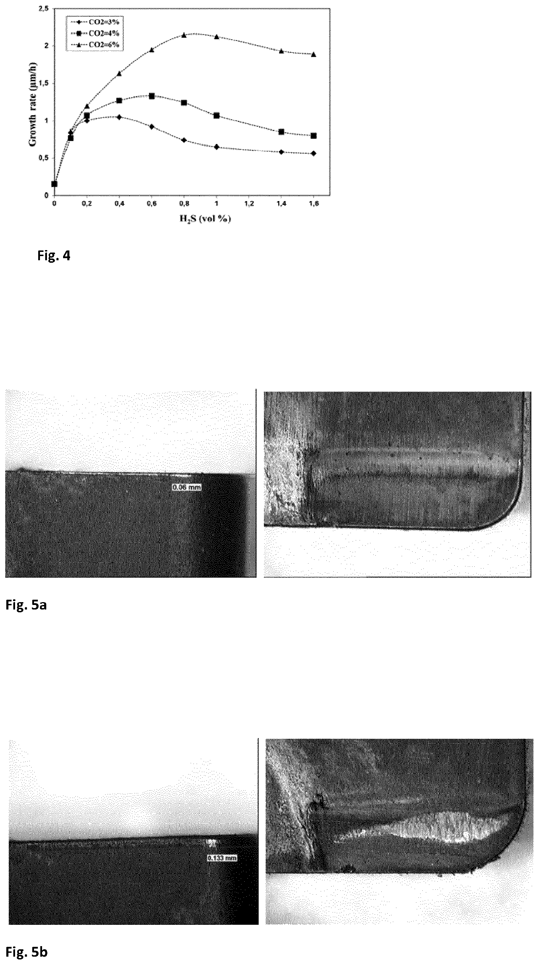

The growth rates of $\alpha$-$Al_2O_3$ are presented in Fig. 4 (texture was not analysed) as a function of $H_2S$ content at $CO_2$ levels of 3 vol %, 4 vol % and 6 vol %. As shown in Fig. 4, the growth rate of $\alpha$-$Al_2O_3$ was strongly dependent on $H_2S$ concentration and the effect of $H_2S$ was more pronounced at higher $CO_2$ levels. Consequently, at higher $CO_2$ levels relatively very high growth rates could be reached at increased levels of $H_2S$ doping. This has been known by persons skilled in the art. Understanding that the $H_2S/CO_2$ ratio determines the process windows for different textures (the fact that had not been understood earlier) a person skilled in the art, can now select very high growth rates with predetermined textures.

The terms "texture" or "fibre texture", as used herein, emphasises that the films or layers have not grown having a random orientation. When the films exhibit the fibre texture one set of geometrically equivalent crystallographic planes {hkl} is found to be oriented parallel to the substrate or the film, while there is a rotational degree of freedom of the fibre axis or growth axis, which is perpendicular this plane. The terms "(hkl) texture" or "(hkl) textured" used here thus means a fibre texture with the {hkl} planes being preferentially oriented parallel to the substrate or the film. The quantity of the texture is measured by XRD and Harris formula (see above) is used to obtain TC(hkl). As herein, when 7 reflections are used in measurement, the maximum TC(hkl) is 7, being a measure of a perfect texture. When TC(hkl) = 1 the structure of the coating is random. Usually, the crystallography of hexagonal crystals is described by using Miller-Bravais indices h, k, i and I. We can, as done here (except Fig. 3), omit the $3^{rd}$ index i, which is i = -(h+k). The (001) plane in $\alpha$-$Al_2O_3$ crystal is parallel to (006) and (00 12) planes and the fibre axis [001] is perpendicular to these planes. The (001) texture is in this case quantified by using either (006) or (00 12) reflection (using Harris formula) and using preferably ICDD's JCPDF-card no. 00-042-1468 or card no.00-010-0173. It is also possible to use (006) XRD reflection only and use JCPDF-card no. 00-046-1212. The XRD (006) reflection, however, is slightly overlapped by a Ti(C,N) reflection but TC(006) can as well be used to quantify (001) texture by using Harris formula. It is further noted that (100) texture) is quantified by using TC(300), also using Harris formula.

It was surprisingly confirmed that $H_2S/CO_2$ ratio can successfully be applied in the temperature range of 600-800 °C to pre-determine the texture of $\alpha$-$Al_2O_3$ layers. It was, also surprisingly, found that $H_2S/CO_2$ ratio is applicable in the pressure range from about 75 to at least 800 mbar. The total pressure affects the ranges of the $H_2S/CO_2$ ratios only slightly. As known, when the total pressure is increased, and the percentage of other reactants are kept constant, the supersaturation of Al donors is relatively constant while the supersaturation of oxygen-donors increases. A strong pressure dependence for the water gas reaction is known to exist. Further, the residence time is increased when the process pressure is increased. It is up to every skilled person in the art to observe these facts and a skilled person can easily find how to adjust the $H_2S/CO_2$ ratios for different pressures. As a rule of thumb for every increment of the total pressure by 25 mbar in the pressure range of 75-800 mbar, the $H_2S/CO_2$ ratio may be increased by 0.001-0.002 depending on the used flow rates (residence time), CVD equipment and hard ware in general (gas distribution system etc.).

The low-temperature process according to this invention is of utmost importance to facilitate $\alpha$-$Al_2O_3$ layers on the recently introduced cubic $Ti_{1-x}Al_xN$ and cubic $Ti_{1-x}Al_xCN$ layers, which would otherwise transform and lose their mechanical properties if heat treated above 800 °C for a longer period. It is emphasized that in this respect it is important to deposit $\alpha$-$Al_2O_3$ layers with as high growth rates as possible to reduce the heat treatment time. The low-temperature $\alpha$-$Al_2O_3$ can be applied on cubic $Ti_{1-x}Al_xN$ or $Ti_{1-x}Al_xCN$ layers produced by CVD or PVD processes.

Other possible coatings, which can be improved by low-temperature $\alpha$-$Al_2O_3$ include layers of nitride, carbonitride or oxycarbonitride of one or more of Al, Ti, Ta, Zr, V and Hf, or combinations thereof deposited using CVD, MT-CVD or PVD processes. Especially textured layers of $TaC_{1-x}N_x$ deposited using CVD with $CH_3CN$, $C_2H_4$ or $CH_4$ as carbon sources are of interest as base layers for low temperature $\alpha$-$Al_2O_3$ to produce/maintain the compressive stresses in the structure.

According to this invention $\alpha$-$Al_2O_3$ can be deposited by chemical vapour deposition (CVD) from the reaction gas comprising 5.0-10 vol%, preferably 6-10 vol% and most preferably 6-8 vol% $CO_2$, 1-4.5 vol%, preferably 1,1-2,2 vol% $AlCl_3$ and 0.01-2.2 vol% $H_2S$, 5-35 vol%, preferably 5-10 vol% $N_2$, 0.5-1.5 vol % HCl, balance $H_2$. Optional additions of 5-15 vol% of CO and 5-15 vol % Ar can be used but are not necessary to obtain the results. The $H_2S/CO_2$ ratio defines the deposition windows for the most important textures i.e. (110), (100), (012), (104) and (001) and, consequently, as shown in Figs. 1-4 and in the Examples, this invention discloses well-defined deposition windows for (110), (001), (012), (104) and (100) textures, respectively. Knowing these limits (keeping the $H_2S/CO_2$ ratio inside the defined deposition window) the other process parameters can be adjusted in a very wide range to achieve and optimize the coating properties, such as growth rate and grain size. It is noted that the CO and Ar are not needed during deposition of $\alpha$-$Al_2O_3$ but can be added and a person skilled in the art can do this without disturbing the idea of this invention. The other dopants, such as $SO_2$, HF, $SF_6$ etc. mentioned in the prior art should not be used since they would disturb the growth of the $\alpha$-$Al_2O_3$ layer

The deposition is made in the temperature range of 600-800°C, preferably 700-800 °C, most preferably preferably 775-800 °C and a pressure range of 75-800 mbar. The pressure can be adjusted individually for different textures.

HCl is usually added to the process gas to increase coating uniformity (variation in the coating thickness). However, HCl has a minor effect in this respect and it reduces the growth rate of $\alpha$-$Al_2O_3$. For this reason, too high amounts of HCl should be avoided and the volume ratio of $AlCl_3$/HCl should be higher than 1, preferably higher than 1.2 and most preferably higher 1.5. This is especially favorable when depositing (001) and (104) textured $\alpha$-$Al_2O_3$. The volume ratio of $CO_2$/$AlCl_3$ ratio should be equal or higher than 4 preferably higher than 4.2.

The $\alpha$-$Al_2O_3$ deposited according to this invention exhibits an X-ray diffraction pattern, as measured using CuKa radiation and theta-2theta scan, with one dominant texture coefficient 4<TC(hkl)<7, selected from the reflections (110), (300), (012), (104), (006) and (00 12). The dominating TC(hkl) being determined by $H_2S/CO_2$ ratio used in the gas mixture and quantified according to Harris formula:

$$TC(hkl) = \frac{I(hkl)}{I_0(hkl)}\left[\frac{1}{n}\sum_{n=1}^{n}\frac{I(hkl)}{I_0(hkl)}\right]^{-1}$$

wherein:

I (h k l) = measured intensity of the (hkl) reflection,

$I_0$ (h k l) = standard intensity of the standard powder diffraction data according to ICDD's JCPDF-card no. 00-042-1468,

n = number of reflections (7) used in the calculation, whereby the (hkl) reflections are:

a) (012), (104), (110), (113), (116), (300) and (00 12) to determine and quantify TC(110), TC(300), TC(012), TC(104) and TC(00 12)
b) (012), (104), (110), (113), (116), (300) and (006) to determine and quantify TC(006).

The disclosed deposition process of $\alpha$-$Al_2O_3$ comprises thus steps with different $H_2S/CO_2$ ratios in the gas mixture to deposit a layer of $\alpha$-$Al_2O_3$ achieve one dominant texture coefficient 4<TC(hkl)<7 selected from the reflections (110), (300), (012), (104), (006) and (00 12):

In one embodiment the texture coefficient TC(006) >4.1, preferably 4.5, most preferably >5.0 and simultaneously TC(110) <1 and TC(100) <1. This is obtained using the $H_2S/CO_2$ regime of 0.16<$H_2S/CO_2$<0.45, preferably 0.18<$H_2S/CO_2$<0.40 and most preferably 0.22<$H_2S/CO_2$<0.35.$CO_2$ is applied in amounts of 5-10 vol%, preferably 6-10 vol%.

The TC(006) being defined as follows:

$$TC(00\ 12) = \frac{I(006)}{I_0(006)}\left[\frac{1}{n}\sum_{n=1}^{n}\frac{I(hkl)}{I_0(hkl)}\right]^{-1}$$

wherein

(h k l) = measured intensity of the (hkl) reflection

$I_0$ (h k l) = standard intensity of the standard powder diffraction data preferably according to JCPDF-card no. 00-042-1468

n = number of reflections used in the calculation, whereby the (hkl) reflections used are: (012), (104), (110), (006), (113), (116) and (300).

In one embodiment the texture coefficient TC(00 12) >4.1, preferably 4.5, most preferably >5.0 and simultaneously TC(110) and TC(100) <1. This is obtained using the $H_2S/CO_2$ regime of 0.16<$H_2S/CO_2$<0.45, preferably 0.18<$H_2S/CO_2$<0.40 and most preferably 0.22<$H_2S/CO_2$<0.35. $CO_2$ is applied in amounts of 5-10 vol%, preferably 6-10 vol%.

The TC(00 12) being defined as follows:

$$TC(00\ 12) = \frac{I(00\ 12)}{I_0(0012)}\left[\frac{1}{n}\sum_{n=1}^{n}\frac{I(hkl)}{I_0(hkl)}\right]^{-1}$$

wherein

(h k l) = measured intensity of the (hkl) reflection

$I_0$ (h k l) = standard intensity of the standard powder diffraction data preferably according to JCPDF-card no. 00-042-1468

n = number of reflections used in the calculation, whereby the (hkl) reflections used are: (012), (104), (110) (113), (116), (300) and (00 12).

In one embodiment the texture coefficient TC(104) >4.0, preferably >4.5 and most preferably >5.0 and simultaneously TC(110) and TC(100) being both less than 1. This is obtained in the $H_2S/CO_2$ regime of 0.08<$H_2S/CO_2$ <0.16, preferably 0.09<$H_2S/CO_2$<0.14. $CO_2$ is applied in amounts of 5-10 vol%, preferably 6-10 vol%.

The TC(104) being defined as follows:

$$TC(104) = \frac{I(104)}{I_0(104)}\left[\frac{1}{n}\sum_{n=1}^{n}\frac{I(hkl)}{I_0(hkl)}\right]^{-1}$$

wherein

(h k l) = measured intensity of the (hkl) reflection

$I_0$ (h k l) = standard intensity of the standard powder diffraction data preferably according to JCPDF-card no. 00-042-1468

n = number of reflections used in the calculation, whereby the (hkl) reflections used are: (012), (104), (110), (113), (116), (300) and (00 12).

In one embodiment the texture coefficient TC(012) >4.0, preferably >4.5 and most preferably >5.0. This is obtained using the $H_2S/CO_2$ regime of 0.02< $H_2S/CO_2$ <0.08, preferably 0.03<$H_2S/CO_2$<0.06. $CO_2$ is applied in amounts of 5-10 vol%, preferably 6-10 vol%.

The TC(012) being defined as follows:

$$TC(012) = \frac{I(012)}{I_0(012)}\left[\frac{1}{n}\sum_{n=1}^{n}\frac{I(hkl)}{I_0(hkl)}\right]^{-1}$$

wherein

(h k l) = measured intensity of the (hkl) reflection

$I_0$ (h k l) = standard intensity of the standard powder diffraction data preferably according to JCPDF-card no. 00-042-1468

n = number of reflections used in the calculation, whereby the (hkl) reflections used are: (012), (104), (110) (113), (116), (300) and (00 12).

In one embodiment the texture coefficient TC(300) >4.0, preferably >4.5 and most preferably >5.0 and simultaneously TC(001) being less than 0.1. This is obtained using the $H_2S/CO_2$ ratio of about 0.01 < $H_2S/CO_2$ <0.02. $CO_2$ is applied in amounts of 5-10 vol%, preferably 6-10 vol%.

The TC(300) being defined as follows:

$$TC(300) = \frac{I(300)}{I_0(300)} \left[ \frac{1}{n} \sum_{n=1}^{n} \frac{I(hkl)}{I_0(hkl)} \right]^{-1}$$

wherein

(h k l) = measured intensity of the (hkl) reflection

$I_0$ (h k l) = standard intensity of the standard powder diffraction data preferably according to JCPDF-card no. 00-042-1468

n = number of reflections used in the calculation, whereby the (hkl) reflections used are: (012), (104), (110) (113), (116), (300) and (00 12).

In one embodiment the texture coefficient TC(110) > 4, preferably > 4.5 and most preferably > 5.0 and simultaneously TC(001) being less than 0.1. This is obtained using the $H_2S/CO_2$ ratio of about $H_2S/CO_2$ <0.01, preferably < 0.008. $CO_2$ is applied in amounts of 5-10 vol%, preferably 6-10 vol%.

The TC(110) being defined as follows:

$$TC(110) = \frac{I(110)}{I_0(110)} \left[ \frac{1}{n} \sum_{n=1}^{n} \frac{I(hkl)}{I_0(hkl)} \right]^{-1}$$

wherein

(h k l) = measured intensity of the (hkl) reflection

$I_0$ (h k l) = standard intensity of the standard powder diffraction data preferably according to JCPDF-card no. 00-042-1468

n = number of reflections used in the calculation, whereby the (hkl) reflections used are: (012), (104), (110) (113), (116), (300) and (00 12).

It should be noticed that the $H_2S/CO_2$ ratio should be adjusted for the deposition pressure to be applied, which can be easily done by a person skilled in the art.

According to the present invention there is thus provided a coated cutting tool insert consisting of a substrate of cemented carbide, cermet, ceramics, steel or a superhard material such as cubic boron nitride (CBN) at least partially coated with a coating with a total thickness of about 20-35 $\mu$m, the coating comprising at least one or more refractory layers of which at least one layer is a (100), (110), (012), (104,) or (001) textured $\alpha$-$Al_2O_3$ of a thickness of 2 to 10 $\mu$m, preferably 3 to 6 $\mu$m (on $Ti_{1-x}Al_xN$ or $Ti_{1-x}Al_xCN$) deposited by chemical vapour deposition (CVD) in the temperature range of 600-800 °C, preferably 700-800 °C and most preferably 775-800 °C above layers comprising:

- one or more face-centered cubic (fcc) $Ti_{1-x}Al_xN$ or $Ti_{1-x}Al_xCN$ layers exhibiting stoichiometric coefficients x from 0.40 to 0.90, preferably from 0.55 to 0.90, most preferably from 0.7 to 0.90 and particularly preferably 0.75 to 0.90,
- one or more $TaC_{1-x}N_x$ layers exhibiting a stoichiometric coefficients x from 0.3 to 0.7, preferably from 0.45 to 0.7 and most preferably from 0.48 to 0.62,
- one or more layers consisting of carbide, nitride, carbonitride or oxycarbonitride of one or more of Al, Ti, Ta, Zr, V and Hf, or combinations thereof or
- combinations of the above-mentioned layers.

The thickness of the $Ti_{1-x}Al_xN$ and $Ti_{1-x}Al_xCN$ layers should be from 0.5 to 20 $\mu$m, preferably 4 to 8.5 $\mu$m. After deposition of $\alpha$-$Al_2O_3$, the $Ti_{1-x}Al_xN$ layers or $Ti_{1-x}Al_xCN$ layers should not exhibit any transformation of the cubic phase i.e. the diffraction peaks of transformation products, such as hexagonal AlN, are absent or have not appeared/increased as a result of the deposition of the alumina layer. Consequently, the said $Ti_{1-x}Al_xN$ layer or $Ti_{1-x}Al_xCN$ layer should contain the same amount of cubic phase as before depositing the alumina layer onto it. Preferably, the $Ti_{1-x}Al_xN$ layer and $Ti_{1-x}Al_xCN$ layers should contain more than 98 % of face-centered cubic (fcc) phase, preferably about or more than 99 % and particularly preferably 100% of fcc phase before and after $\alpha$-$Al_2O_3$ deposition. This can be verified by using XRD and using, for example, the PDF card 00-046-1200 as a reference. Other reliable PDF cards can also be applied. As shown in the examples all the $Ti_{1-x}Al_xN$ layers exhibited 100% of cubic (fcc) phase after $\alpha$-$Al_2O_3$ deposition according to the invention.

According to one preferred embodiment of the present invention the (001) textured $\alpha$-Al$_2$O$_3$ layer with TC(006) or TC(00 12) >4.1, preferably >4.5, most preferably >5.0 and particularly preferably >5.5 and simultaneously exhibiting TC(110) <1 and TC(100) <1 is deposited using a H$_2$S/CO$_2$ ratio of 0.18<H$_2$S/CO$_2$<0.40 and most preferably 0.22< H$_2$S/CO$_2$<0.35. Simultaneously, the CO$_2$ concentration should be between 5 and 10 vol%, preferably between 6 and 10 vol%, most preferably between 6 and 8 vol%. The coating is deposited at 600-800 °C, preferably at 700-800 °C, and most preferably at 775-800 °C and in a pressure range of 80-800 mbar, preferably 100-400 mbar and most preferably 180-250 mbar. In these circumstances a growth rate of about 1.2-2 $\mu$m/h can be achieved. It is within the purview of the person skilled in the art to adjust the process parameters to achieve the desired growth rates and optimize the texture.

According to one preferred embodiment of the present invention the (104) textured $\alpha$-Al$_2$O$_3$ with TC(104) >4.0, preferably >4.5 and most preferably >5.0 and simultaneously exhibiting TC(110) <1 and TC(100) <1 is deposited using a H$_2$S/CO$_2$ volume ratio of 0.08<H$_2$S/CO$_2$<0.16, preferably 0.09<H$_2$S/CO$_2$<0.14 and most preferably 0.095<H$_2$S/CO$_2$ <0.12. Simultaneously, the CO$_2$ concentration should be between 5 and 10 vol%, preferably between 6 and 10 vol%, most preferably between 6 and 8 vol%. The deposition temperature is 700-800 °C, preferably 775-800 °C and is carried out in a pressure range of 75-400 mbar, preferably 120-320 mbar. In these circumstances a growth rate of about 1.2-2 $\mu$m/h can be achieved. It is within the purview of the person skilled in the art to adjust the process parameters to achieve the desired growth rates and optimized texture.

According to one preferred embodiment of the present invention the (012) textured $\alpha$-Al$_2$O$_3$ with TC(012) >4.5, preferably >5.0 and most preferably >5.5 and simultaneously exhibiting TC(110) <1 and TC(001) <1 is deposited using a H$_2$S/CO$_2$ volume ratio of 0.02<H$_2$S/CO$_2$<0.08, preferably 0.03<H$_2$S/CO$_2$<0.06. Simultaneously, the CO$_2$ cocentration should be between 5 and 10 vol%, preferably between 6 and 10 vol%, most preferably between 6 and 8 vol%. The deposition temperature is 700-800 °C, preferably at 775-800 °C and the process carried out in a pressure range of 180-500 mbar, preferably 150-300 mbar. In these circumstances a growth rate of about 1.2-2 $\mu$m/h, preferably 1.5-2 $\mu$m/h could be achieved. It is within the purview of the person skilled in the art to adjust the process parameters to achieve the desired growth rates and texture.

In one embodiment the texture coefficient TC(110) >4, preferably >4.5 and most preferably >5.0 and simultaneously exhibiting TC(001) <1 is deposited using the H$_2$S/CO$_2$ ratio of about H$_2$S/CO$_2$ <0.01, preferably < 0.008. Simultaneously, the CO$_2$ concentration should be between 5 and 10 vol%, preferably between 6 and 10 vol%, most preferably between 6 and 8 vol%. The deposition temperature is 700-800 °C, preferably at 775-800 °C and the process carried out in a pressure range of 80-500 mbar, preferably 100-500 mbar and most preferably 110-250 mbar. In these circumstances a growth rate of about 1.2-2.0, preferably 1.5-2.0 $\mu$m/h can be achieved. It is within the purview of the person skilled in the art to adjust the process parameters to achieve the desired growth rates and texture.

In one embodiment the texture coefficient TC(300) >4.0, preferably >4.5 and most preferably >5.0 and simultaneously exhibiting TC(001) <1 is deposited using the H$_2$S/CO$_2$ ratio of about 0.01< H$_2$S/CO$_2$ <0.02. Simultaneously, the CO$_2$ concentration should be between 5 and 10 vol%, preferably between 6 and 10 vol%, most preferably between 6 and 8 vol%. The deposition temperature is 700-800 °C, preferably at 775-800 °C and the process carried out in a pressure range of 80-500 mbar, preferably 100-500 mbar and most preferably 110-250 mbar. In these circumstances a growth rate of about 1.2-2.0 $\mu$m/h could be achieved. It is within the purview of the person skilled in the art to adjust the process parameters to achieve the desired growth rates and texture.

The thickness of the inventive (001), (104), (012), (110) and (100) textured $\alpha$-Al$_2$O$_3$ layers is preferably about 2-10 $\mu$m. When deposited on Ti$_{1-x}$Al$_x$N or Ti$_{1-x}$Al$_x$CN layers the $\alpha$-Al$_2$O$_3$ layers thickness is preferably about 3-6 $\mu$m. The coating time is thus limited to about or less than 4 hours (corresponding to coating thickness of 4.8-8 $\mu$m of $\alpha$-Al$_2$O$_3$ in this case) to shorten the heat-treatment time and thus avoid transformation of the cubic Ti$_{1-x}$Al$_x$N layers. As shown in the Examples the transformation of the cubic Ti$_{1-x}$Al$_x$N could be eliminated. If $\alpha$-Al$_2$O$_3$ will be deposited to a thickness of about 4 $\mu$m, the coating time can be reduced to about 2 hours. It should be noted that if coating thickness of the textured $\alpha$-Al$_2$O$_3$ layer is reduced to about 3 $\mu$m (according to prior art) the deposition time could be reduced to about or less than 2.5-1.5 hours. Consequently, according to this invention well-controlled $\alpha$-Al$_2$O$_3$ textures can be deposited at low temperature with relatively short deposition time. This is an important improvement over the prior art, WO2018/138255 (A1).

In one embodiment the CO$_2$/AlCl$_3$ volume ratio in the reaction chamber should be higher than 4.0, preferably higher than 4.2 and the volume ratio of AlCl$_3$/HCl should be higher than 1, preferably higher than 1.2 and most preferably higher 1.5. When these limitations are applied together with H$_2$S/CO$_2$ deposition windows defined for (001), (104), (012), (110) and (100) finer grain size together with higher growth rates can be achieved. Consequently, the inventive (001), (104), (012), (110) and (100) textured $\alpha$-Al$_2$O$_3$ layers are composed of columnar grains with a grain width (W) being less than 0.7 $\mu$m, preferably less than 0.5 $\mu$m W being an average of the width of 25 consecutive grains of $\alpha$-Al$_2$O$_3$ measured on a polished cross-section of the $\alpha$-Al$_2$O$_3$ coating by SEM along a straight line parallel to the coating placed in the middle of the said $\alpha$-Al$_2$O$_3$ coating.

In one embodiment the inventive $\alpha$-Al$_2$O$_3$ layers are deposited on Ti$_{1-x}$Al$_x$N layer obtained by low-pressure moderate temperature CVD referred to as LP-MTCVD (applying the bonding layer according to the invention). The

$Ti_{1-x}Al_xN$ layers can be obtained using 0.01-0.1 vol % $TiCl_4$, 0.12-0.25 vol% $AlCl_3$, 0.1-1.1 vol % $NH_3$, balance $H_2$, and with optional additions of $N_2$, at a temperature of 630-770 °C and at a pressure of 4-10 mbar, preferably 4-8 mbar and most preferably 4-6 mbar to a thickness of of 0.5 to 20 $\mu$m, preferably 2 to 10 $\mu$m and most preferably 4 to 8 $\mu$m. Stoichiometric constants x of the $Ti_{1-x}Al_xN$ and $Ti_{1-x}Al_xCN$ layers should be from 0.40 to 0.90, preferably from 0.55 to 0.90, most preferably from 0.7 to 0.90 and particularly preferably 0.75 to 0.90. It is within the purview of the person skilled in the art to adjust the process parameters to achieve and ensure the desired cubic phase and texture of the $Ti_{1-x}Al_xN$ layer by controlling $TiCl_4/NH_3$, $AlCl_3/NH_3$ ratios, optional $N_2$ additions, deposition temperature and last but not least the deposition pressure.

In one embodiment the inventive $\alpha$-$Al_2O_3$ layers are deposited on $TaC_{1-x}N_x$ layers (applying the bonding layer according to the invention) obtained using CVD from a mixture comprising 0.2-3.2 vol% $CH_3CN$ or 0.3-2.1 vol % $C_2H_4$ as carbon/nitrogen sources, 0.8-5 vol %, preferably 1.2-3.6 vol % $TaCl_5$, 5-40 vol% $N_2$, balance $H_2$ and Ar in the temperature range of 700-1000 °C, preferably 775-950 °C and in the pressure range of 5 to 500, preferably 5-250 mbar. In combination with low temperature alumina the preferred deposition temperature of the $TaC_{1-x}N_x$ layer is 775-840 °C. When using acetonitrile, $CH_3CN$, the texture can be controlled by $TaCl_5/CH_3CN$ ratio together with $TaCl_5/(H_2+N_2)$ and $CH_3CN/(H_2+N_2)$ ratios. In addition, $H_2/N_2$ ration is of importance. It is within the purview of the person skilled in the art to adjust the process parameters to achieve the desired texture/textures. At the deposition temperatures higher than 775°C the $TaC_{1-x}N_x$ layer exhibits a stoichiometric coefficient x being $0.3<x<0.7$, preferably x is 0.45-0.7 and most preferably 0.48-0.62. The $TaC_{1-x}N_x$ layer is preferably deposited on 0.5-5 $\mu$m, preferably 0.5-2 $\mu$m thick MTCVD Ti(C,N) layer. A thin (0.2-0.5 $\mu$m) layer of TiN can be applied first on the cemented carbide substrate. The MTCVD Ti(C,N) and TiN layers are deposited at a temperature of 800-860 °C. The thickness of the $TaC_{1-x}N_x$ layer is from about 2 to about 25 $\mu$m, preferably 5-15 $\mu$m and most preferably 5-10 $\mu$m and the layer has the following preferred crystallographic growth directions: [111], [220] or [311], preferably [111].

The $TaC_{1-x}N_x$ layer exhibits a texture coefficient TC(111) >3.8, preferably >4.2, the texture coefficient being defined as follows:

$$TC(111) = \frac{I(111)}{I_0(111)}\left[\frac{1}{n}\sum_{n=1}^{n}\frac{I(hkl)}{I_0(hkl)}\right]^{-1}$$

or a texture coefficient TC(220)> 3.5, preferably >4, the texture coefficient being defined as follows:

$$TC(220) = \frac{I(220)}{I_0(220)}\left[\frac{1}{n}\sum_{n=1}^{n}\frac{I(hkl)}{I_0(hkl)}\right]^{-1}$$

or a texture coefficient TC(311) >3.5, preferably >4, the texture coefficient being defined as follows:

$$TC(311) = \frac{I(311)}{I_0(311)}\left[\frac{1}{n}\sum_{n=1}^{n}\frac{I(hkl)}{I_0(hkl)}\right]^{-1}$$

wherein:

I (h k l) = measured intensity of the (hkl) reflection,
$I_0$ (h k l) = standard intensity of the standard powder diffraction data according to JCPDF-card no. 00-035-0801 or any relevant data.
n = number of reflections (5) used in the calculation, whereby the (hkl) reflections are (111), (200), (220), (311) and (222).

It was surprisingly found that, typically, when $\alpha$-$Al_2O_3$ was deposited according to this invention on the $TaC_{1-x}N_x$ intermediate layers thermal cracks were absent on the surface of the alumina layer. This is obviously due to compressive stresses present in the $TaC_{1-x}N_x$ layer.

In one embodiment the surfaces of the (001), (104), (012), (110) and (100) textured $\alpha$-$Al_2O_3$ layers are characterized in that thermal cracks

In one embodiment the inventive $\alpha$-$Al_2O_3$ layers are deposited on $Ti_{1-x}Al_xN$, $Th_{1-x}Al_xCN$, MT-CVD Ti(C,N) and $TaC_{1-x}N_x$

intermediate layers using a bonding layer of (Ti,Al)(C,O,N) having a thickness of 0.1 to 2 $\mu$m deposited from a gas mixture comprising 2.5-15 vol% CO, 0.5-5.5 vol% $TiCl_4$, 0.8-2.2 vol% $CH_3CN$, 0.5-1.5 vol% HCl, 0.5-1.5 vol% $AlCl_3$, 5-35 vol% $N_2$ balance $H_2$ characterized in that 0.8-2.2 vol% $CH_3CN$ and 0.5-1.5 vol% $AlCl_3$ are present in the gas mixture during deposition and that the deposition of bonding and oxidation layers are performed at the same temperature as the $\alpha$-$Al_2O_3$ layer. The bonding layer is deposited by continuously changing the contents of precursors so that the volume fractions of $AlCl_3$ and CO are increased and volume fractions of $CH_3CN$ and HCl are decreased during deposition. The maximum amount of $AlCl_3$ and CO should be reached about 2 min before the end of the process.

It is recommended to use a $H_2$ purge (1-2 min) immediately after depositing the (Ti,Al)(C,O,N) layer. After this, before oxidation, the surface of the (Ti,Al)(C,O,N) layer bonding is treated using a mixture of 0.5-3 vol%, preferably 0.5-1 vol% $AlCl_3$, balance $H_2$ for 1-5 min. It is recommended to use a $H_2$ purge (1-2 min) also after this treatment. The bonding layer is then oxidized (to ensure nucleation of $\alpha$-$Al_2O_3$) using a gas mixture comprising 0.5-3.2 vol%, preferably 2.8-3.2 vol% $CO_2$, 2.5-20 vol% CO, 5-35 vol% $N_2$ and balance $H_2$. It is important to use of 4< $CO/CO_2$ <9, preferably the $CO/CO_2$ ratio should be 5-9 during oxidization. The duration of the oxidation step is 2-6 min and it is within the purview person skilled in the art to adjust the process parameters to achieve the desired level of oxidation to result in nucleation of pure $\alpha$-$Al_2O_3$ with good adhesion.

In one embodiment the oxidation step is followed by an additional post-treatment using a mixture of of 0.5-7.5 vol% $AlCl_3$, 0.15-1.8 vol% $TiCl_4$, balance $H_2$ The $AlCl_3/TiCl_4$ volume ratio should be higher than 2, preferably 2-5 and most preferably 2-3. This treatment ensures nucleation of the alpha phase, especially if lower temperatures are used and further contributes to finer grain size and enhanced adhesion and texture. The treatment is followed by a $H_2$ purge of 2-4 min. The importance of the $CO/CO_2$ ratio during oxidation and the post-treatments of the oxidized surface has not been realized in the prior art. These treatments ensure nucleation of the alpha phase, especially if lower temperatures are used, and further contributes to finer grain size and enhanced adhesion and texture.

The inventive $\alpha$-$Al_2O_3$ is deposited onto this surface applying $H_2S$ directly on the pre-treated bonding layer. During the first 2-5 min the amount of $H_2S$ can, if found necessary, be 40-60 % of the amount used later in the process. The person skilled in the art can optimize the duration of this step without jeopardizing the adhesion. After this step deposition of $\alpha$-$Al_2O_3$ is performed using a specific $H_2S/CO_2$ process windows as defined in this invention to obtain the preferred texture.

Consequently, in one embodiment, $H_2S$ is applied immediately on an oxidized bonding layer after being treated with $AlCl_3$ and/or $TiCl_4$, as described above.

In one embodiment TiN, preferably, Ti(C,N) layer is deposited first on the cubic $Ti_{1-x}Al_xN$ layer, followed by a bonding layer of (Ti,Al)(C,O,N) described above.

In another preferred embodiment of the cutting tool insert of the present invention the coating comprises a layer between the $Ti_{1-x}Al_xN$, $Ti_{1-x}Al_xCN$ or $TaC_{1-x}N_x$ layers and the substrate surface, the first layer consisting of carbide, nitride, carbonitride or oxycarbonitride of one or more of Al, Ti, Ta, Zr, V and Hf, or combinations thereof deposited using CVD or MTCVD, having a thickness of from 0.5 to 10 $\mu$m, preferably the first layer is consisting of titanium carbonitride Ti(C,N) and most preferably of TiN. The abbreviation MT-CVD used here refers to a well-known technique where Ti(C,N) is deposited employing $TiCl_4$, $CH_3CN$, $N_2$, HCl and $H_2$, in a temperature range of 790-900 °C in this case 790-860 $\underline{o}$C.

In one embodiment the $Ti_{1-x}Al_xN$ or $Ti_{1-x}Al_xCN$ layer below the inventive $\alpha$-$Al_2O_3$ layers comprises more than 98%, preferably 99% and most preferably 100% face-cantered cubic (fcc) phase before and after deposition of the $\alpha$-$Al_2O_3$ layer. This is achieved by depositing the $\alpha$-$Al_2O_3$ layer with high growth rate and at temperatures in the range of 700-800 °C, preferably 775-800 °C. In this way the transformation of the cubic $Ti_{1-x}Al_xN$ phase can totally be eliminated.

In one embodiment the $TaC_{1-x}N_x$ and $Ti_{1-x}Al_xCN$ layers below the inventive $\alpha$-$Al_2O_3$ layers exhibit stoichiometric constants x from 0.40 to 0.90, preferably from 0.55 to 0.90, most preferably from 0.7 to 0.90 and particularly preferably 0.75 to 0.90.

In one embodiment the $TaC_{1-x}N_x$ layer below the inventive $\alpha$-$Al_2O_3$ layers exhibits stoichiometric coefficients x being 0.3<x<0.7, preferably x is 0.45-0.7 and most preferably 0.48-0.62.

In one embodiment the inventive (110), (100), (012) and (104) textured $\alpha$-$Al_2O_3$ layers according to the invention are deposited on CVD $TaC_{1-x}N_x$ layers using the bonding layers described in this application. The thickness of the $TaC_{1-x}N_x$ layer is from about 2-25 $\mu$m, preferably 5 to 15 $\mu$m and most preferably 5-10 $\mu$m and $TaC_{1-x}N_x$ layers are characterized in that the $TaC_{1-x}N_x$ layer exhibits (111), (220) or (311) textures as measured using X-ray diffraction using CuKa radiation and theta-2theta scan. The texture coefficients being quantified by using Harris formula.

In one embodiment the inventive (110), (100), (012), (104) and (001) textured $\alpha$-$Al_2O_3$ layers are above 2 to 25 $\mu$m, preferably 5-15 $\mu$m and most preferably 5-10 $\mu$m thick $TaC_{1-x}N_x$ layer the said layer exhibiting one of the following texture coefficients:

TC(111) >3.8, preferably >4.2 or TC(220) >3.5, preferably >4 or TC(311) >3.5, preferably> 4.

In one embodiment no thermal cracks can be detected on top of the (001), (104), (012), (110) and (100) textured $\alpha$-$Al_2O_3$ layers deposited on $TaC_{1-x}N_x$ intermediate layers when examined by OM or SEM, preferably, after polishing or blasting the alumina layer directly or by applying polishing or blasting or any other post treatment to remove any additional layers eventually deposited on the alumina layer to reveal the alumina surface for observation by OM or SEM.

The severity of the thermal crack on alumina layers deposited on intermediate coating materials herein can be alleviated as described below:

It has surprisingly been found that $Al_2O_3$ can be obtained at very low temperatures 400-600 °C, preferably 450-500 °C from a gas mixture comprising high percentage of $H_2S$ and $CO_2$ together with high deposition pressure of the order of 400-800 mbar, preferably 600-800 mbar. When the deposition process is carried out under these conditions and applied onto $\alpha$-$Al_2O_3$ layers the coating adopts the crystallography (alpha form) of alumina without any specific bonding nucleation procedures. This low temperature approach can then be applied to fill the thermal cracks in alumina layers formed during a cooling down period. Such coatings with filled thermal cracks can further be coated by low temperature processes like PVD or wet chemical processes like electroplating.

In still one embodiment $\alpha$-$Al_2O_3$ layer is deposited at 400-600 °C onto a preferably (001) textured $\alpha$-$Al_2O_3$ coating after cooling from a deposition temperature to about 400-500 °C, preferably to about 400-450 °C. Usually at these temperatures the thermal stresses are large enough have caused the coating to crack. When a low-temperature $\alpha$-$Al_2O_3$ is deposited for 10-30 min on top of this layer the cracks will be filled. It is up to a person skilled in the art do define the temperature at which the cracking has occurred. After this a low T $\alpha$-$Al_2O_3$ process is performed to fill the thermal cracks at about 400-450 °C and from a pressure from about 300 to 800 mbar, the gas mixture comprising 8-12 vol%, preferably 8-10 vol% $CO_2$, 1,6-2.2 vol% $H_2S$, 1,5-4 vol% $AlCl_3$, balance $H_2$ with optional addition of $N_2$. This coating can then be coated by any coating formed at low temperature by any process including low temperature CVD coating, PVD coating or a wet chemical process like electroplating. The elimination of the thermal cracks increases the chipping resistance of the $\alpha$-$Al_2O_3$ layer. The absence of the thermal cracks was especially pronounced when an intermediate layer of $TaC_{1-x}N_x$ was applied.

The absence of the thermal cracks can be detected on top of the alumina layer when examined by OM or SEM, preferably, after polishing or blasting the alumina layer directly or by applying polishing or blasting or any other post treatment to remove any additional layers eventually deposited on the alumina layer to reveal the alumina surface for observation by OM or SEM.

In still one embodiment there is a coating layer atop one of the textured $\alpha$-$Al_2O_3$ layer according to this invention as a wear indicator or as a layer of other functions, consisting of carbide, nitride, carbonitride or oxycarbonitride of one or more of Ti, Zr, V and Hf, or combinations thereof, which can be provided using PVD or low temperature CVD or a wet chemical process like electroplating.

In yet another preferred embodiment of the cutting tool insert of the present invention the substrate consists of cemented carbide, preferably of cemented carbide consisting of 4 to 12 wt-% Co, optionally 0.5-10 wt-% cubic carbides of the metals from groups IVb, Vb and VIb of the periodic table, preferably Ti, Nb, Ta or combinations thereof, and balance WC. For steel machining applications the cemented carbide substrate preferably contains 5.5 to 9,0 wt-% cubic carbides of the metals from groups IVb, Vb and VIb of the periodic table, preferably Ti, Nb and Ta, and for cast iron machining applications the cemented carbide substrate preferably contains 0.3 to 3,0 wt-% cubic carbides of the metals from groups IVb, Vb and VIb of the periodic table, preferably Ti, Nb and Ta.

In yet another preferred embodiment of the cutting tool insert of the present invention the substrate consists of cemented carbide comprising a binder phase enriched surface zone having a thickness of 5 to 30 $\mu$m, preferably 10 to 25 $\mu$m.

Preferably, the binder phase enriched surface zone of the cemented carbide body is essentially free from cubic carbides. The binder enriched surface zone enhances toughness of the substrate and widens the application range of the tool. Substrates having a binder enriched surface zone are particularly preferred for cutting tool inserts for metal cutting operations in steel, whereas cutting tool inserts for metal cutting operations in cast iron are preferably produced without binder enriched surface zone.

The present invention further provides a method of manufacturing a cutting tool insert. According one preferred embodiment there is thus provided a method to manufacture a coated cutting tool insert consisting of a substrate of cemented carbide, cermet, ceramics, steel or a superhard material such as cubic boron nitride (CBN) at least partially coated with a coating with a total thickness of maximum of 35 $\mu$m, the coating comprising at least one or more refractory layers of which at least one layer is a fibre-textured $\alpha$-$Al_2O_3$ having a thickness of 2-10 $\mu$m, preferably 3-6 $\mu$m deposited on one or more layers comprising carbide, nitride, carbonitride or oxycarbonitride of one or more of Al, Ti, Ta, Zr, V and Hf, or combinations thereof especially including one or more $Ti_{1-x}Al_xN$ or $Ti_{1-x}Al_xCN$ layers or one or more textured layers of $TaC_{1-x}N_x$ or combinations of these. The $\alpha$-$Al_2O_3$ layer is deposited by chemical vapour deposition (CVD) from the reaction gas comprising 5-10 vol%, preferably 6-8 vol% $CO_2$, 1-4.5 vol%, preferably 1.5- 2.2 vol% $AlCl_3$, 0.5-1.5 vol% HCl and 0.01-2.2 vol % $H_2S$, 5-35 $N_2$, preferably 5-10 vol% of $N_2$, balance $H_2$. The volume ratio of $H_2S/CO_2$ is used to determine the texture that will be formed in the $\alpha$-$Al_2O_3$ layer. Deposition is performed in a temperature range of 600-800 °C, preferably 700-800°C, and most preferably 775-800 °C. The inventive $\alpha$-$Al_2O_3$ layers are applied using bonding and nucleation steps disclosed.

The method also discloses a (Ti,Al)(C,O,N) the bonding layer, which is crucial to obtain the texture and coating properties and can be applied on all intermediate layers discussed here, the said bonding layer being characterized by higher oxygen and aluminium contents towards the top of the bonding layer (the volume fractions of $AlCl_3$ and CO are increased and volume fractions of $CH_3CN$ and HCl are decreased during deposition). The maximum amount of $AlCl_3$ and CO should be reached about 2 min before the end of the process followed by a special treatment before oxidation. Oxidation is carried out at the same temperature as the $\alpha$-$Al_2O_3$ layer from a gas mixture comprising 0.5-3.2 vol%, preferably 2.8-3.2 vol% $CO_2$, 2.5-20 vol% CO, 5-35 vol% $N_2$ balance $H_2$ with optional additions of Ar. The $CO/CO_2$ volume ratio is from 4 to 9, preferably from 5 to 9 during the oxidation step (duration 2-6 min).

In one embodiment of the method the surface of the (Ti,Al)(C,O,N) bonding layer is treated before oxidation using a mixture of 0.5-3 vol%, preferably 0.5-1 vol% $AlCl_3$, balance $H_2$ for 1-5 min.

In one embodiment of the method the $CO_2/AlCl_3$ and $AlCl_3/HCl$ ratios are given. The volume ratio of $CO_2/AlCl_3$ ratio should be equal or higher than 4 preferably higher than 4.2. The volume ratio of $AlCl_3/HCl$ should be higher than 1, preferably higher than 1.2 and most preferably higher than 1.5. This kind of process data enhances growth rate and texture and, further, contributes to grain refinement of $\alpha$-$Al_2O_3$.

In one embodiment of the method the oxidation step is followed by a post-treatment using a mixture of 0.5-7.5 vol% $AlCl_3$, 0.15-1.8 vol% $TiCl_4$, balance $H_2$ using the $AlCl_3/TiCl_4$ volume higher than 2, preferably 2-5 and most preferably 2-3. This treatment ensures nucleation of the alpha phase, especially if lower temperatures are used and further contributes to finer grain size and enhanced adhesion and texture.

In one embodiment of the method the growth rate of the inventive $\alpha$-$Al_2O_3$ layers is 1.2-2.0 $\mu$m/h, preferably 1.5-2.0 $\mu$m/h.

In one embodiment of the method $\alpha$-$Al_2O_3$ process process is characterized by the presence of 5-35 vol %, preferably 5-10 vol% of $N_2$.

DESCRIPTION OF THE DRAWINGS

The present invention is described in more details with reference to the accompanying drawings, wherein:

Fig. **1** shows one preferred embodiment of the invention, where the TC(hkl) development as function of $H_2S$ at 3.25 vol% $CO_2$ is depicted,

Fig. **2** shows one preferred embodiment of the invention, where the TC(hkl) development as function of $H_2S$ at 6.25 vol% $CO_2$ is depicted,

Fig. **3** shows one more preferred embodiment of the invention, where the regimes of $H_2S/CO_2$ ratios are defined,

Fig. **4** shows still one more embodiment of the invention where the influences of $H_2S$ and $CO_2$ on the growth rate of $\alpha$-$Al_2O_3$ layers are shown,

Fig. **5a** shows a LOM (light optical microscope) image of the flank face and rake face of the cutting tool in accordance with one embodiment of the invention,

Fig. **5b** shows a LOM (light optical microscope) image of the flank face and rake face of the cutting tool in accordance with prior art,

Fig. **6 a-c** show the SEM (scanning electron microscope) surface images of the surfaces of (001), (012) and (110) textured $\alpha$-$Al_2O_3$ coatings, respectively, deposited in accordance with one embodiment of the invention.

EXAMPLES

In the present examples cemented carbide substrates for cutting inserts with a composition of 6.0 wt% Co and balance WC (hardness about 1600 HV) and cemented carbides containing 5.5 wt% Co and about 8 wt% cubic carbides facilitating a binder enrich zone of about 15-20 $\mu$m were coated in a commercial CVD reactor. The following insert geometries were used SNUN140408, CNMG120412 and CNMA120408.

Example 1a - Invention, $Ti_{1-x}Al_xN$ base layer:

The cemented carbide substrates were coated with coatings comprising the following layers from the surface of the cemented carbide substrate:

a) TiN,
b) $Ti_{1-x}Al_xN$,
c) TiN
d) Ti(C,N)
e) (Ti,Al)(C,O,N) bonding layer
f) $AlCl_3$ treatment

g) Oxidation

h) $AlCl_3/TiCl_4$ treatment

a). The first coating layer on cemented carbide was TiN, which was deposited onto the cemented carbide substrate from a mixture of 2.2-5,2 vol% $TiCl_4$, 45-55 vol% $N_2$, balance $H_2$ at a temperature of 860 °C and at a pressure of 150-200 mbar.

After this the temperature was reduced to 730 °C and the pressure was reduced to about 6 mbar.

b).The $Ti_{1-x}Al_xN$ layer was deposited using 0.01-0.1 vol % $TiCl_4$, 0.14-0.25 vol% $AlCl_3$, 0.1-1 vol % $NH_3$, balance $H_2$, and with optional additions of $N_2$, at a temperature of 730 °C and at a pressure of 6 mbar to a thickness of about 5 $\mu$m. It is within the purview of the person skilled in the art to adjust the process parameters to achieve and ensure the desired cubic phase and texture of the $Ti_{1-x}Al_xN$ layer by controlling $TiCl_4/NH_3$, $AlCl_3/NH_3$ ratios, optional $N_2$ additions, deposition temperature and last but not least the deposition pressure. In these examples the $Ti_{1-x}Al_xN$ layer was controlled to be composed of 100 % cubic $Ti_{1-x}Al_xN$ by XRD.

After deposition of the $Ti_{1-x}Al_xN$ layer the bonding and nucleation layers were applied:

c). A thin TiN layer having a thickness of 0.05-0.5 $\mu$m was deposited first onto the $Ti_{1-x}Al_xN$ layer from mixture comprising 0.1-0.4 vol% $TiCl_4$, 0.8-1.2 vol% $NH_3$, balance $H_2$ at the same temperature and pressure as the $Ti_{1-x}Al_xN$ layer itself at a pressure of 6 mbar.

d). After this the temperature was raised to the temperature used for alumina deposition, preferably, to 775-800 °C and a thin 0.1-0.2 $\mu$m thick MTCVD Ti(C,N) layer was applied using 3.1-4.2 vol% $TiCl_4$, 0.3-0.8 vol% $CH_3CN$, 5-35 $N_2$ balance $H_2$ at a pressure of 100 mbar.

e). On to this surface a (Ti,Al)(C,O,N) bonding layer was deposited to a thickness of about 0.6-0.8 $\mu$m from a gas mixture comprising the following precursors ramped linearly from the start to end of end of the process step (duration about 20 min). Start = 0 min, End = 20 min:

- 1.2 vol% CO at 0 min increased linearly to 3.8 vol% at 20 min,
- 3.8 vol% $TiCl_4$ at 0 min increased linearly to 5.2 vol% at 20 min,
- 1.2 vol% HCl at 0 min decreased linearly to 0 vol% at 15 min,
- 0.6 vol% $CH_3CN$ at 0 min decreased linearly to 0 vol% at 15 min (no $CH_3CN$ during the last 5 min),
- 0.5 vol% $AlCl_3$ at 0 min increased linearly to 1.5 vol% at 18 min, 1.8 vol% $AlCl_3$ between 18 min to 20 min.
- 30 vol% $N_2$,
- balance $H_2$.

f). The $H_2$ purge of 2-4min was applied immediately after deposition, followed by a treatment with 0.5 vol% $AlCl_3$ balance $H_2$ for 2 minutes.

g). This surface was then oxidized from a gas mixture comprising 2.8-3.2 vol% $CO_2$, 2.5-20 vol% CO, 5-12 vol% $N_2$, balance $H_2$ at a pressure of 40-60 mbar and at the same temperature as will be used for alumina layer itself. The $CO/CO_2$ ratio was 5.1 during this step. The duration of the oxidation step is from about 2 to about 6 min.

h). The oxidation step was followed by an additional treatment using a mixture of 1.2 vol% $AlCl_3$, 0.5 vol% $TiCl_4$, balance $H_2$ (the $AlCl_3/TiCl_4$ ratio being higher than 2) in order to increase nucleation density and ensure the alpha-phase even at lower temperature. The treatment was followed by a $H_2$ purge of 3 min. These processes (e) - (h)were performed at a pressure of about 40-70 mbar.

The $\alpha$-$Al_2O_3$ layers according to the invention wherein the texture was determined by the $H_2S/CO_2$ ratio were deposited onto this surface, Example 3.

Example 1b - Invention $TaC_{1-x}N_x$ base layer:

The cemented carbide substrates were coated with coatings comprising the following layers from the surface of the cemented carbide substrate:

a). TiN,
b). Ti(C,N)

c). $TaC_{1-x}N_x$ with (222), (220) or (311) textures

d) Ti(C,N)

e). (Ti,Al)(C,O,N) bonding layer

f). $AlCl_3$ treatment

g). Oxidation

h). $AlCl_3/TiCl_4$ treatment

a). The first coating layer on cemented carbide was TiN, which was deposited onto the cemented carbide substrate from a mixture of 2.2-5,2 vol% $TiCl_4$, 45-55 vol% $N_2$, balance $H_2$ at a temperature of 840 °C and at a pressure of 150-200 mbar.

b). After this a thin MTCVD Ti(C,N) layer having a thickness of 0.1-0.5 $\mu$m was deposited onto the TiN layer at the same temperature from mixture comprising 2.2-5.2 vol% $TiCl_4$, 0.44-0.65 vol% $CH_3CN$, 5-35 $N_2$ balance $H_2$ at a pressure of 75 mbar.

c). $TaC_{1-x}N_x$ layers were deposited onto the MTCVD Ti(C,N) layer from a mixture comprising 0.6-1.2 vol% $CH_3CN$, 3.6-4.8 vol % $TaCl_5$, 22 vol% $N_2$, 10 vol% Ar balance $H_2$ at 840 °C and at a pressure of 100-200 mbar. The texture was controlled by $TaCl_5/CH_3CN$ ratio together with $TaCl_5/(H_2+N_2)$ and $CH_3CN /(H_2+N_2)$ ratios to be (111), (220) or (311). The $TaC_{1-x}N_x$ layers were deposited to a thickness of about 5 $\mu$m.

d). Before deposition of the bonding and alumina layers a thin 0.1-0.3 $\mu$m MTCVD Ti(C,N) layer was applied on the $TaC_{1-x}N_x$ layer using similar data as above (b).

e)-h). The bonding and oxidation procedures were made according to Example 1a(e-h) at the same temperature as the previous layers. After this the temperature was adjusted to those used for alumina depositions. The $\alpha$-$Al_2O_3$ layers according to the invention wherein the texture was determined by the $H_2S/CO_2$ ratio were deposited onto this surface, Examples 3 and 4.

Example 2 - reference coatings:

Coatings 1 P and 2P were deposited as a reference on top of the $Ti_{1-x}Al_xN$ and $TaC_{1-x}N_x$ layers from Examples 1a and 1b using the bonding and nucleation procedure according to the prior art, Table 1. (Nucleation procedures described in 1a(e-h) and 1b(e-h) were not used).

Coating 1P: $\alpha$-$Al_2O_3$ layers were deposited on $Ti_{1-x}Al_xN$ and $TaC_{1-x}N_x$ layers from Examples 1a and 1b. Nucleation and bonding procedures as well as the alumina layer were deposited following procedures presented in WO2018/138255 (A1). The oxidation was performed by using $CO_2$ = 8.8 vol% and CO = 3.5 vol %. Relatively long uncatalyzed ($H_2S$=0) period of 30 min was used and after this period $H_2S$ was added in the reaction gas mixture at the $H_2S/CO_2$ ratio of 0.5. The $\alpha$-$Al_2O_3$ was deposited to a thickness 4 $\mu$m at 850 °C. It is clear from Table 1 that too high a $H_2S/CO_2$ ratio did not result in acceptable level of TC(00 12).

Coating 2P: $\alpha$-$Al_2O_3$ layers were deposited using the same process as in 1P but instead applying the $H_2S/CO_2$ ratio of 0.12 typically used in the prior art. As shown in Table 1 this resulted in very low (001) texture [low TC(00 12) and TC(006)] and in relatively high TC(012).

Table 1.

| Coating | Temp °C | P mbar | $CO_2$ [vol%] | $H_2S$ [vol%] | $AlCl_3$ [vol%] | CO [vol%] | N2 [vol%] | H2 [vol%] | TC (00 12) | $H_2S/CO_2$ ratio |
|---|---|---|---|---|---|---|---|---|---|---|
| 1 P (prior art) | 850 | 100 | 2,7 | 1.34 | 1.2 | 0.4 | 0 | bal | 3.95 | 0.5 |
| 1 P (prior art) | 850 | 100 | 2.7 | 0.38 | 1.2 | 0.4 | 0 | bal | 2.2 | 0.12 |

Example 3 - Invention ($\alpha$-$Al_2O_3$):

In this example $\alpha$-$Al_2O_3$ layers according to this invention having and exhibiting clear (110), (100), (012), (104) and (001) textures were deposited on top of the $Ti_{1-x}Al_xN$ and $TaC_{1-x}N_x$ layers (examples 1a and 1b) to a thickness of about 4 $\mu$m (Coating 3-7, Table 2). $H_2S$ was added immediately to the process (after the purge of $H_2$) and deposition

of $\alpha$-$Al_2O_3$ was performed to the desired thickness using the specific $H_2S/CO_2$ ratios to obtain the preferred textures. 5 vol% $N_2$ was used to supress diffusion/transport of W and Co from the substrate to the interface and in the alumina layer. The following $H_2S/CO_2$ ratios were used: 0.008, 0.015, 0.05, 0.12 and 0.22 (Referred to as Coatings 3-7, respectively, Table 2).

It is noted that Coating 3 with profound TC(110) exhibited very low TC(001) and TC(104) being both <1, Coating 4 with profound TC(300) exhibited very low TC(001) and TC(104) being both <1 and Coating 5 with profound TC(012) exhibited very low TC(110) and TC(001) being both <1 and Coating 6 with profound TC(104) exhibited very low TC(110) <1 and TC(100) being both <1 and Coating 7 with profound TC(00 12) exhibited very low TC(110), TC(100) and TC(012) being all <1. This is also evident from Fig. 1.

Table 2.

| Coating | Temp °C | P mbar | $CO_2$ [vol%] | $AlCl_3$ [vol%] | HCl [vol%] | CO [vol%] | $H_2S/CO_2$ | TC(hkl) |
|---|---|---|---|---|---|---|---|---|
| 3 (invention) | 800 | 200 | 6.25 | 1.23 | 0.7 | 1.0 | 0.008 | TC(110) = 5.1 |
| 4 (invention) | 800 | 200 | 6.25 | 1.32 | 0.7 | 1.0 | 0.015 | TC(100) = 4,5 |
| 5 (invention) | 800 | 150 | 6.25 | 1.32 | 0.7 | 1.0 | 0.05 | TC(012) = 5.2 |
| 6 (invention) | 800 | 150 | 6.25 | 1.32 | 0.7 | 1.0 | 0.12 | TC(104) = 4.9 |
| 7 (invention) | 800 | 150 | 6.25 | 1.32 | 0.7 | 1.0 | 0.22 | TC(001) = 5.5 |

Example 4 - invention:

In this example the $Ti_{1-x}Al_xN$ layer from Example 1a was coated with 4 $\mu$m (001)-textured $\alpha$-$Al_2O_3$ using $H_2S/CO_2$ ratio of 0.18< $H_2S/CO_2$ <0.24. The Coatings 8-16 were deposited with controlled $H_2S/CO_2$ regimes but with different process data. As can be seen in Table 3 relatively very high growth rates (considering the deposition temperature) could be obtained with well-controlled (001) texture. The heat-treatment of the underlaying layer was minimized and transformation of $Ti_{1-x}Al_xN$ could be avoided as analysed by XRD (details in Table 5). As clear from this example the other process parameters, such as pressure and $CO_2$ concentration can varied in wide limits when keeping the $H_2S/CO_2$ ratio in given limits.

Table 3.

| Coating | T [°C] | P [mbar] | $CO_2$ [vol%] | $H_2S$ [vol%] | $AlCl_3$ [vol%] | CO [vol%] | HCl [vol%] | H2 [vol%] | TC (00 12) | $H_2S/CO_2$ ratio |
|---|---|---|---|---|---|---|---|---|---|---|
| 8 (invention) | 800 | 80 | 5.8 | 1.04 | 1.22 | 1.0 | 0.7 | bal | 4,4 | 0.18 |
| 9 (invention) | 800 | 120 | 5.5 | 1.1 | 1.22 | 1.0 | 0.7 | bal | 5.1 | 0.20 |
| 10 (invention) | 800 | 160 | 6.25 | 1.25 | 1.32 | 1.0 | 0.7 | bal | 4.7 | 0.18 |
| 11 (invention) | 800 | 220 | 6.25 | 1.38 | 1.32 | 1.0 | 0.6 | bal | 5.5 | 0.22 |
| 12 (invention) | 775 | 320 | 6.25 | 1.38 | 1.32 | 1.0 | 0.7 | bal | 5.3 | 0.22 |
| 13 (invention) | 780 | 320 | 5.25 | 1.52 | 1.12 | 1.0 | 0.7 | bal | 5.9 | 0.29 |
| 14 (invention) | 785 | 350 | 6.25 | 1.60 | 1.12 | 1.0 | 1 | bal | 5.6 | 0.26 |

(continued)

| Coating | T [°C] | P [mbar] | $CO_2$ [vol%] | $H_2S$ [vol%] | $AlCl_3$ [vol%] | CO [vol%] | HCl [vol%] | H2 [vol%] | TC (00 12) | $H_2S/CO_2$ ratio |
|---|---|---|---|---|---|---|---|---|---|---|
| 15 (invention) | 775 | 350 | 8.25 | 1.65 | 1.12 | 1.0 | 1 | bal | 4.6 | 0.20 |
| 16 (invention) | 770 | 450 | 8.25 | 1.98 | 1.12 | 1.0 | 1 | bal | 4.8 | 0.24 |

<u>Example 5 - invention:</u>

A $TaC_{1-x}N_x$ layer layer with (111) texture from Example 1b and a MTCVD layer with same thickness from Example 1b wa coated with (001) textured $\alpha$-$Al_2O_3$ using and $H_2S/CO_2$ ratio of 0.22 (Coating 11, Table 3). After deposition, during cooling down period, a gas mixture comprising 8-12 vol%, preferably 8-10 vol% $CO_2$, 1,5-4% $AlCl_3$, and 1.6-2.2% $H_2S$, balance $H_2$ was shunted in the reactor for 15 min at a pressure of 400 mbar and in the temperature range of 440 °C to close the thermal cracks (if any) developed in $\alpha$-$Al_2O_3$. The inspection using SEM and OM did not reveal any thermal cracks. This coating is referred to as Coating 17 in Table 4. Table 4 also gives the process data for the "alumina flash" i.e. low temperature deposition of $\alpha$-$Al_2O_3$ during cooling.

Table 4.

| Coating | T [°C] | P [mbar] | $CO_2$ [vol%] | $H_2S$ [vol%] | $AlCl_3$ [vol%] | CO [vol%] | HCl [vol%] | $H_2$ [vol%] | TC (00 12) | $H_2S/CO$ ratio |
|---|---|---|---|---|---|---|---|---|---|---|
| 17 | 800 | 500 | 6.25 | 1.38 | 1.12 | 1.0 | 0.7 | bal | 5.5 | 0.22 |
| Alumina flash | 400 | 800 | 8.28 | 2.0 | 1.83 | 0 | 0 | bal | ------- | |

<u>Example 6 - thermal stability of $Ti_{1-x}Al_xN$- comparative example:</u>

The coatings according to prior art P1 and P2 and coatings 8-16 (invention) deposited on $Ti_{1-x}Al_xN$ from Example 1a were compared (Coatings 9,12 were excluded). The growth rates, XRD analysis and deposition time needed to obtain 4 $\mu$m of $\alpha$-$Al_2O_3$ are given. As can be seen in Table 5, relatively very high growth rates (considering the deposition temperature) could be obtained with well-controlled (001)-textures according to the invention. The deposition time of the inventive coatings was shortened to about 2-4.4 hours as compared with about 7-8 hours needed for the coatings produced according to prior art. Consequently, the heat-treatment was minimized and transformation of $Ti_{1-x}Al_xN$ could be avoided as analysed by XRD. As clear from this example all the $Ti_{1-x}Al_xN$ layers coated with the inventive $\alpha$-$Al_2O_3$ layers exhibited 100 % of cubic phase exhibiting no transformation as a result of the deposition of the $\alpha$-$Al_2O_3$ layers.

Table 5.

| Coating | Growth rate ($\mu$m) | Cubic TiAlN (%) | Depositions time to obtain 4 $\mu$m layer (h) |
|---|---|---|---|
| P1 (prior art) | 0.6 | 87 | 6.7 |
| P2 (prior art) | 0.4 | 68 | 8 |
| 8 (invention) | 1.2 | 100 | 3.3 |
| 10 (invention) | 1.3 | 100 | 3.1 |
| 11 (invention) | 1.9 | 100 | 2.1 |
| 13 (invention) | 1.4 | 100 | 2.9 |
| 14 (invention) | 1.6 | 100 | 2.5 |
| 15 (invention) | 1.2 | 100 | 3.3 |
| 16 (invention) | 0.9 | 100 | 4.4 |

Example 7- TaC$_{1-x}$N$_x$ layers

The TaC$_{1-x}$N$_x$ layers with (111), (220) and (311) textures from Example 1b were analysed using XRD with respect to phase and texture, Table 6. The textured TaC$_{1-x}$N$_x$ were after this coated with 4 μm thick α-Al$_2$O$_3$ layers using the deposition data of Coating 11, Table 3. The resulting coatings were thus composed of about 5 μm thick (111), (220) and (311) textured TaC$_{1-x}$N$_x$ and about 4μm thick (001)-textured α-Al$_2$O$_3$. These coating are referred to as Coatings 18,19 and 20.

Table 6.

| Coating | Texture of TaC$_{1-x}$N$_x$ | Stoichiometric coefficient x |
|---------|------------------------------|-------------------------------|
| 18 | TC(111) = 4.6 | 0.47 |
| 19 | TC(220) = 3.9 | 0.51 |
| 20 | TC(311) = 4.3 | 0.49 |

Example 8 - Turning Test:

Coating 11 according to Example 3 and Coating P1 (prior art) according to Example 2 were deposited on Ti$_{1-x}$Al$_x$N layers from Example 1a and tested in carbon steel (C45) without coolant using the following cutting parameters:

Geometry: WNMG: 120408
Cutting speed (Vc) = 300 m/min
Feed (f) = 0,4 mm/rev
Depth of cut (a$_p$) = 2,5 mm.

The flank and rake faces of the insert with Coating 11 (invention) after turning for 9 min are shown in Fig. 5a: flank face on the left and rake face on the right.
The flank and rake faces of the insert with Coating P1 (reference) after turning for 3 min are shown in Fig. 5b: flank face on the left and rake face on the right.
The insert according to the invention (Fig. 5a) showed considerably less flank wear and crater wear. The enhanced performance of the insert produced according to the invention was clear.

Example 9 - Edge Toughness Tests:

The prior art α-Al$_2$O$_3$ layers (P1 and P2) and α-Al$_2$O$_3$ layers 11,13 and 18 according to invention were deposited using the base layers from Example 1a and 1b on CNMG120412 inserts and compared with respect to edge toughness (chipping resistance) in longitudinal turning of cast iron (GG25) using the following cutting parameters:

Insert geometry: CNMG120412
Cutting speed: v$_c$ = 260 m/min
Feed (f) = 0,32 mm/rev
Depth of cut: a$_p$ = 2,5 mm

The inserts were inspected after 2 and 8 minutes of cutting. As shown in Table 7, compared to the prior art coatings, the edge toughness was considerably enhanced when the coating was produced according to this invention. The coating with TaC$_{1-x}$N$_x$ intermediate layer (Coating 18) showed less edge chipping possibly due to reduced thermal stresses and/or possibly due to compressive stresses maintained in TaC$_{1-x}$N$_x$.

Table 7.

| Coating | Base Layer | Flaking of the edge line (%) after 2 minutes | Flaking of the edge line (%) after 8 minutes |
|---------|-----------|----------------------------------------------|----------------------------------------------|
| P1 (prior art) | Ti$_{1-x}$Al$_x$N | 4 | 22 |
| P2 (prior art) | Ti$_{1-x}$Al$_x$N | 6 | 25 |
| 11 (invention) | Ti$_{1-x}$Al$_x$N | 2 | 10 |

(continued)

| Coating | Base Layer | Flaking of the edge line (%) after 2 minutes | Flaking of the edge line (%) after 8 minutes |
|---|---|---|---|
| 13 (invention) | $Ti_{1-x}Al_xN$ | 2 | 9 |
| 18 (invention) | $TaC_{1-x}N_x$ | 0 | 6 |

Those skilled in the art will appreciate that numerous changes and modification can be made to the preferred embodiments without departing from the spirit of the invention. It is, therefore, to be understood that the invention is not limited to the disclosed exemplary embodiments; on the contrary, it is intended to cover various modifications and equivalent arrangements within the append claims.

**Claims**

1. A coated cutting tool consisting of a substrate of cemented carbide, cermet, ceramics, steel or a superhard material such as cubic boron nitride (CBN) at least partially coated with a coating consisting one or more refractory layers comprising $Ti_{1-x}Al_xN$, $Th_{1-x}Al_xCN$, $Ti(C,N)$ or $TaC_{1-x}N_x$ or combinations thereof and an outer wear resistant layer of textured $\alpha$-$Al_2O_3$ of a thickness of 2-10 $\mu$m, preferably 3 to 6 $\mu$m, deposited by chemical vapour deposition (CVD) wherein the said $\alpha$-$Al_2O_3$ exhibits an X-ray diffraction pattern, as measured using $CuK_\alpha$ radiation and theta-2theta scan, and texture coefficients TC(hkl) being determined according to Harris formula

$$TC(hkl) = \frac{I(hkl)}{I_0(hkl)}\left[\frac{1}{n}\sum_{n=1}^{n}\frac{I(hkl)}{I_0(hkl)}\right]^{-1}$$

wherein:

I (h k l) = measured intensity of the (hkl) reflection
$I_0$ (h k l) = standard intensity of the standard powder diffraction data according to ICDD's JCPDF-card no. 00-042-1468,
n = number of reflections (7) used in the calculation, wherein the (hkl) reflections are either

   a): (012), (104), (110), (113), (116), (300) and (00 12) or
   b): (012), (104), (006), (110), (113), (116) and (300),

**characterized by**

   a texture coefficient TC(110) >4.0, preferably >4.5 and simultaneously exhibiting TC(001) <1 and TC(104) <1, calculated according to a),
   or
   a texture coefficient TC(300) >4.0, preferably >4.5 and simultaneously exhibiting TC(001)<1 and TC(104)<1, calculated according to a),
   or
   a texture coefficient TC(012) >4.0, preferably >4.5 and simultaneously exhibiting TC(110)<1 and TC(001)<1, calculated according to a),
   or
   a texture coefficient TC(104) >4.0 and simultaneously exhibiting TC(110)<1 and TC(100)<1, calculated according to a),
   or
   a texture coefficient TC(006) >4.1, preferably >4.5 and most preferably >5.0, and particularly preferably >5.5 and simultaneously exhibiting TC(110) <1 and TC(100) <1, calculated according to b),
   or
   a texture coefficient TC(00 12) >4.1, preferably >4.1 and most preferably >4.5 and particularly preferably >5.5 and simultaneously exhibiting TC(110) <1 and TC(100) <1, calculated according to a).

2. The coated cutting tool of claim 1 wherein the $\alpha$-Al$_2$O$_3$ layer is composed of columnar grains exhibiting a grain width (W) being less than 0.7 $\mu$m, preferably less than 0.5 $\mu$m wherein (W) being an average of the width of 25 consecutive grains of $\alpha$-Al$_2$O$_3$ measured on the polished cross-section of the $\alpha$-Al$_2$O$_3$ coating by SEM along a straight line parallel to the coating placed the middle of the said $\alpha$-Al$_2$O$_3$ layer.

3. The coated cutting tool of claims 1 and 2 wherein the coating comprises one or more Ti$_{1-x}$Al$_x$N or Ti$_{1-x}$Al$_x$CN layers of a thickness of 0.5 to 20 $\mu$m, preferably 2 to 10 $\mu$m and most preferably 4 to 8 $\mu$m below the $\alpha$-Al$_2$O$_3$ layer **characterized in that** the said Ti$_{1-x}$Al$_x$N and Ti$_{1-x}$Al$_x$CN layers exhibit the stoichiometric coefficients x being higher than 0.40, preferably higher than 0.55, most preferably higher than 0.70 and particularly preferably higher than 0.75 comprising of more than 98 %, preferably 99% and most preferably 100% of face-centered-cubic (fcc) crystal structure.

4. The coated cutting tool of claims 1 and 2 wherein the refractory layer below the $\alpha$-Al$_2$O$_3$ layer is composed of TaC$_{1-x}$N$_x$ of a thickness of 2 to 25 $\mu$m, preferably, 5 to 15 $\mu$m and most preferably 5 to 10 $\mu$m having a stoichiometric coefficients x from 0.3 to 0.7, preferably from 0.45 to 0.7 and most preferably from 0.48 to 0.62.

5. The coated cutting tool of claim 4 **characterized in that** TaC$_{1-x}$N$_x$ layer exhibits
a texture coefficient TC(111) >3.8, preferably >4.2,
or
a texture coefficient TC(220) >3.5, preferably >4.0,
or
a texture coefficient TC(311) >3.5, preferably >4.0,
the texture coefficient being as defined as follows,

$$TC(311) = \frac{I(hkl)}{I_0(hkl)}\left[\frac{1}{n}\sum_{n=1}^{n}\frac{I(hkl)}{I_0(hkl)}\right]^{-1}$$

wherein:

I (h k l) = measured intensity of the (hkl) reflection,
I$_0$ (h k l) = standard intensity of the standard powder diffraction data according to JCPDF-card no. 00-035-0801 or any relevant PDF card.
n = number of reflections (5) used in the calculation, whereby the (hkl) reflections are (111), (200), (220), (311) and (222).

6. The coated cutting tool of any of the previous claims **characterized in that** one more layers between the substrate and the $\alpha$-Al$_2$O$_3$ layer comprises carbide, nitride, carbonitride or oxycarbonitride of one or more of Al, Ti, Ta, Zr, V and Hf, or combinations thereof with a thickness from about 0.5 to 20 $\mu$m, preferably, 4-8.5 $\mu$m.

7. The coated cutting tool according to any of the previous claims **characterized in that** there is a coating layer atop the $\alpha$-Al$_2$O$_3$ layer as a wear indicator or as a layer of other functions, consisting of carbide, nitride, carbonitride or oxycarbonitride of one or more of Al, Ti, Ta, Zr, V and Hf, or combinations thereof, which can be provided using PVD or moderate temperature CVD (MTCVD) or a wet chemical process like electroplating.

8. The coated cutting tool of any previous claims **characterized in that** no thermal cracks can be detected in the alumina layer when examined by OM or SEM after polishing or blasting the alumina layer directly or by applying polishing or blasting or any other post treatment to remove any additional layers eventually deposited on the said alumina layer to reveal the alumina surface for observation by OM or SEM.

9. The coated cutting tool of any of the previous claims wherein the substrate consists of cemented carbide or binder enriched cemented carbide, cemented carbide bulk consisting of 4 to 12 wt-% Co, optionally 0.5-10 wt-% cubic carbides of the metals from groups IVb, Vb and VIb of the periodic table, preferably Ti, Nb, Ta or combinations thereof, and balance WC.

10. A method of manufacturing a coated cutting tool insert, preferably according to any of the foregoing claims, comprising the steps of coating a substrate of cemented carbide, cermet, ceramics, steel or cubic boron nitride with a coating of a maximum thickness of 35 $\mu$m consisting of one or more refractory layers comprising carbide, nitride, carbonitride or oxycarbonitride of one or more of Al, Ti, Ta, Zr, V and Hf, preferably $Ti_{1-x}Al_xN$, $Ti_{1-x}Al_xCN$ or $TaC_{1-x}N_x$ or combinations thereof and an outer wear resistant layer of textured $\alpha$-$Al_2O_3$ of a thickness of 2-10 $\mu$m, preferably 3-6 $\mu$m deposited by chemical vapour deposition (CVD) in a temperature range of 600-800 °C, preferably 700-800 °C and most preferably 775-800 °C and in a pressure range of 75-800 mbar, preferably 120-500 mbar from the reaction gas mixture comprising 5.0-10 vol%, preferably 6-10 vol% and most preferably 6-8 vol % $CO_2$, 1-4.5 vol%, preferably 1,1-2,2 vol% $AlCl_3$ and 0.01-2.2 vol% $H_2S$, 5-35 vol%, preferably 10-35 vol% $N_2$, 0.5-1.5 vol % HCl, balance $H_2$ with optional additions of 0.5-15 vol% CO, and 5-15 vol % Ar,

**characterized in that**

the deposition process comprises the use of specific $H_2S/CO_2$ volume ratios in the gas mixture to deposit highly textured $\alpha$-$Al_2O_3$ layers as follows:

$H_2S/CO_2$ <0.01, preferably $H_2S/CO_2$ <0.008 results in the formation of (110) textured $\alpha$-$Al_2O_3$ layer exhibiting TC(110) >4, preferably >4.5 and most preferably >5 with TC(001) and TC(104) being both simultaneously less than 1,

0.01< $H_2S/CO_2$ <0.02, preferably 0.01< $H_2S/CO_2$<0.015 results in the formation of (100) textured an $\alpha$-$Al_2O_3$ layer exhibiting TC(300) >4, preferably >4.5 and most preferably >5 with TC(001) and TC(104) both being simultaneously less than 1,

0.02< $H_2S/CO_2$ <0.08, preferably 0.03<$H_2S/CO_2$<0.06 results in the formation of (012) textured $\alpha$-$Al_2O_3$ layer exhibiting TC(012) >4, preferably >4.5 and most preferably >5 with TC(110) and TC(001) both being simultaneously less than 1,

0.08<$H_2S/CO_2$<0.16, preferably 0.09<$H_2S/CO_2$<0.14 and most preferably 0.095<$H_2S/CO_2$ <0.12 results in the formation of (104) textured $\alpha$-$Al_2O_3$ layer exhibiting TC(104) higher than 4.0, preferably higher than 4.5 most preferably higher than 5.0 with TC(110) and TC(100) both being simultaneously less than 1,

0.16<$H_2S/CO_2$<0.45, preferably 0.18<$H_2S/CO_2$<0.40 and most preferably 0.22<$H_2S/CO_2$<0.35 results in the formation of (001) textured $\alpha$-$Al_2O_3$ layer exhibiting TC(006) or TC(00 12) higher than 4.1, preferably higher than 4.5 and most preferably higher than 5 with TC(110) and TC(100) being both simultaneously less than 1,

The texture coefficients, TC(hkl), being measured by XRD using $CuK_\alpha$ radiation and quantified according to the Harris formula

$$TC(hkl) = \frac{I(hkl)}{I_0(hkl)}\left[\frac{1}{n}\sum_{n=1}^{n}\frac{I(hkl)}{I_0(hkl)}\right]^{-1}$$

wherein:

I (h k l) = measured intensity of the (hkl) reflection

$I_0$ (h k l) = standard intensity of the standard powder diffraction data according to ICDD's JCPDF-card no. 00-042-1468,

n = number of reflections (7) used in the calculation, wherein the (hkl) reflections are (012), (104), (110), (113), (116), (300) and (00 12).

11. The method of claim 10 wherein the said $\alpha$-$Al_2O_3$ layer is deposited applying bonding layer of (Ti,Al)(C,O,N) having a thickness of 0.1 to 2 $\mu$m deposited from a gas mixture comprising 2.5-15 vol% CO, 0.5-4.4 vol% $TiCl_4$, 0.5-1.5 vol% HCl, 0.5-1.5 vol% $AlCl_3$, 5-35 vol%, preferably 20-35 vol% $N_2$, balance $H_2$ **characterized in that** 0.8-5.2 vol% $CH_3CN$, 5-35 vol%, preferably 20-35 vol% $N_2$ and 0.5-1.5 vol% $AlCl_3$ are simultaneously present in the gas mixture during deposition and that the deposition is performed at the same temperature as the $\alpha$-$Al_2O_3$ layer.

12. The method of claims 10-11, wherein the bonding layer of claim 11 is **characterized in that** the volume fractions of $AlCl_3$ and CO are increased and volume fractions of $CH_3CN$ and HCl are decreased in a controlled way towards the top surface of the bonding layer and that the surface of said bonding layer being post-treated in the mixture of 0.5-3 vol%, preferably 0.5-1 vol% $AlCl_3$, balance $H_2$.

13. The method of claims 10-12 wherein the oxidation of the surface of said bonding layer being performed at the same temperature as the $\alpha$-$Al_2O_3$ layer from a gas mixture comprising 0.5-3.2 vol%, preferably 2.8-3.2 vol% $CO_2$, 2.5-20

vol% CO, 5-35 vol% $N_2$ balance $H_2$ with optional additions of Ar, **characterized in that** the volume ratio $CO/CO_2$ is from 4 to 9, preferably from 5 to 9 during the oxidation step, the said oxidation step being followed by a post-treatment using a gas mixture comprising 0.5-7.5 vol% $AlCl_3$, 0.5-1.8 vol% $TiCl_4$, balance $H_2$ wherein the $AlCl_3/TiCl_4$ volume ratio is higher than 2, preferably 2-5 and most preferably 2-3.

14. The method according to claims 10-13 wherein,

(001) textured $\alpha$-$Al_2O_3$ exhibiting either TC(006) or TC(00 12) >4.1, preferably >4.5 and most preferably >5 and particularly preferably >5.5, simultaneously exhibiting TC(110) <1 and TC(100) <1 is deposited using 5.0-10 vol%, preferably 6-10 vol% and most preferably 6-8 vol% $CO_2$ with the $H_2S/CO_2$ volume ratio of 0.18-0.40, preferably 0.22-0.35 in a pressure range of 80-800 mbar, preferably 100-400 mbar and most preferably 180-250 mbar exhibiting a growth rate of about 1.2-2.0 $\mu$m/h, preferably 1.5-2.0 $\mu$m/h,
or
(104) textured $\alpha$-$Al_2O_3$ exhibiting a TC(104) >4.0, preferably >4.5, simultaneously exhibiting TC(110) <1 and TC(100) <1 is deposited using 5.0-10 vol%, preferably 6-10 vol% and most preferably 6-8 vol % $CO_2$ and with the $H_2S/CO_2$ volume ratio of $0.08<H_2S/CO_2<0.16$, preferably $0.09<H_2S/CO_2<0.14$ and most preferably $0.095<H_2S/CO_2 <0.12$ in a pressure range of 75-400 mbar, preferably 120-320 mbar exhibiting a growth rate of 1.2-2.0 $\mu$m/h, preferably 1.5-2.0 $\mu$m/h,
or
(012) textured $\alpha$-$Al_2O_3$ exhibiting a TC(012) >4.5, preferably >5.0 and most preferably >5.5, simultaneously exhibiting TC(110) <1 and TC(001) <1, is deposited using 5.0-10 vol%, preferably 6-10 vol% and most preferably 6-8 vol % $CO_2$, with the $H_2S/CO_2$ volume ratio of 0.02-0.08, preferably 0.03-0.06 in a pressure range of 80-800 mbar, preferably 100-400 mbar and most preferably 180-250 mbar exhibiting a growth rate of 1.2-2.0 $\mu$m/h, preferably 1.5-2.0 $\mu$m/h,
or
(100) textured $\alpha$-$Al_2O_3$ exhibiting a TC(100) >4.5, preferably >5.0 and most preferably >5.5, simultaneously exhibiting TC(001) <1 and TC(104) <1, is deposited using 5.0-10 vol%, preferably 6-10 vol% vol % $CO_2$ and most preferably 6-8 vol % $CO_2$ with the $H_2S/CO_2$ volume ratio of 0.01-0.02, preferably 0.01-0.015 in a pressure range of 80-500 mbar, preferably 100-500 mbar and most preferably 110-250 mbar exhibiting a growth rate of 1.2-2.0 $\mu$m/h, preferably 1.5-2.0 $\mu$m/h,
or
(110) textured $\alpha$-$Al_2O_3$ exhibiting a TC(110) >4.5, preferably >5.0 and most preferably >5.5, simultaneously exhibiting TC(001) <1 and TC(104) <1, is achieved at a $H_2S/CO_2$ volume ratio of $H_2S/CO_2<0.01$, preferably $H_2S/CO_2 < 0.008$ using 5.0-10 vol%, preferably 6-10 vol% $CO_2$, and most preferably 6-8 vol % $CO_2$ at a pressure range of 80-500 mbar, preferably 100-500 mbar and most preferably 110-250 mbar exhibiting a growth rate of 1.2-2.0 $\mu$m/h, preferably 1.5-2.0 $\mu$m/h.

15. The method of any of claims 10-14 wherein the volume ratio of $AlCl_3/HCl$ is higher than 1, preferably higher than 1.2 and most preferably higher 1.5 and simultaneously the volume ratio of $CO_2/AlCl_3$ being equal or higher than 4 preferably higher than 4.2.

Fig. 1

Fig. 2

Fig. 3

Fig. 4

Fig. 5a

Fig. 5b

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5137774 A
- US 5700569 A
- US 5654035 A
- US 5980988 A
- US 5863640 A
- US 6333103 B
- US 6869668 B
- US 7094447 B
- US 20060199026 A
- US 20060141271 A

- US 7993742 B2
- EP 1953258 B1
- US 2008187774 B2
- US 7763346 B2
- EP 01479 B1
- US 7201956 B
- US 20180274091 A1
- US 8389134 B
- US 6572991 B1
- WO 2018138255 A1